# EUROPEAN PATENT SPECIFICATION

(11) **EP 2 842 163 B1**
(45) Date of publication and mention of the grant of the patent: **21.03.2018**
(21) Application number: 12875510.5
(22) Date of filing: 25.04.2012
(51) Int. Cl.: H01L 45/00

(54) **NONLINEAR MEMRISTORS**
NICHTLINEARE MEMRISTOREN
MEMRISTANCES NON LINÉAIRES

(43) Date of publication of application: 04.03.2015
(73) Proprietor: Hewlett Packard Enterprise Development LP, Houston, TX 77070 (US)
(72) Inventor: YANG, Jianhua, Palo Alto, California 94304-1100 (US); ZHANG, Minxian Max, Palo Alto, California 94304-1100 (US); PICKETT, Matthew D., Palo Alto, California 94304-1100 (US); WILLIAMS, R. Stanley, Palo Alto, California 94304-1100 (US)
(74) Representative: Arigita Lasheras, Jesús José
(86) International application number: PCT/US2012/035024
(87) International publication number: WO 2013/162553

(56) References cited:
- US-A1- 2008 197 333
- US-A1- 2011 182 103
- US-A1- 2011 309 321
- US-A1- 2012 085 985

## Description

### BACKGROUND

The continuous trend in the development of electronic devices has been to minimize the sizes of the devices. While the current generation of commercial microelectronics are based on sub-micron design rules, significant research and development efforts are directed towards exploring devices on the nano-scale, with the dimensions of the devices often measured in nanometers or tens of nanometers. In addition to the significant reduction of individual device size and much higher packing density as compared to microscale devices, nanoscale devices may also provide new functionalities due to physical phenomena on the nanoscale that are not observed on the micron scale.

For instance, electronic switching in nanoscale devices using titanium oxide as the switching material has recently been reported. The resistive switching behavior of such a device has been linked to the memristor circuit element theory originally predicted in 1971 by L.O. Chua. The discovery of the memristive behavior in the nanoscale switch has generated significant interest, and there are substantial on-going research efforts to further develop such nanoscale switches and to implement them in various applications. One of the many important potential applications is to use such a switching device as a memory unit to store digital data.

In order to be competitive with CMOS FLASH memories, the emerging resistive switches need to have a switching endurance that exceeds at least millions of switching cycles. Reliable switching channels inside the device may significantly improve the endurance of these switches. Different switching material systems are being explored to achieve memristors with desired electrical performance, such as high speed, high endurance, long retention, low energy and low cost.

Reference is made to US 2012/0085985 A1, which discloses an electrically actuated device that includes a reactive metal layer, a first electrode established in contact with the reactive metal layer, an insulating material layer established in contact with the first electrode or the reactive metal layer, an active region established on the insulating material layer, and a second electrode established on the active region. A conductive nano-channel is formed through a thickness of the insulating material layer.

Document US 2011/182103 describes GCIB-treated resistive devices formed by a lower electrode and an oxide material on the lower electrode. The oxide material is exposed to a gas cluster ion beam (GCIB) until a change in resistance of a first portion of the oxide material relative to the resistance of a second portion of the oxide material. An upper electrode is formed on the first portion. Document US 2008/197333 describes a memory device having a first electrode, a second electrode, and memory material defining an inter-electrode current path between the first electrode and the second electrode. A gap is formed by shrinkage of the shrinkable material between the memory material and a shrinkable material next to the memory material. The present invention is defined by the independent device claim 1 and by the independent method claim 11.

### BRIEF DESCRIPTION OF THE DRAWINGS

FIGS. 1A-1C are each a side elevational view, depicting an example of a memristor device based on principles disclosed herein.

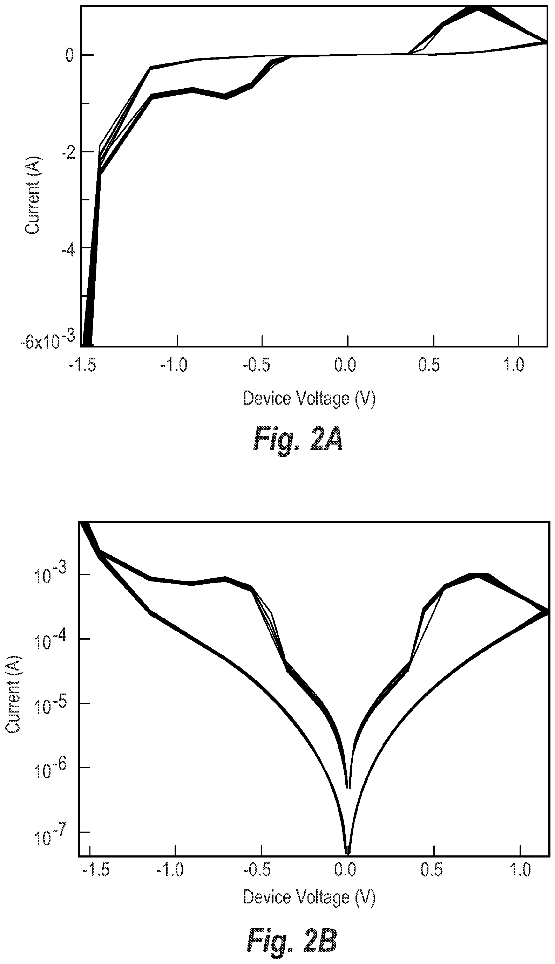

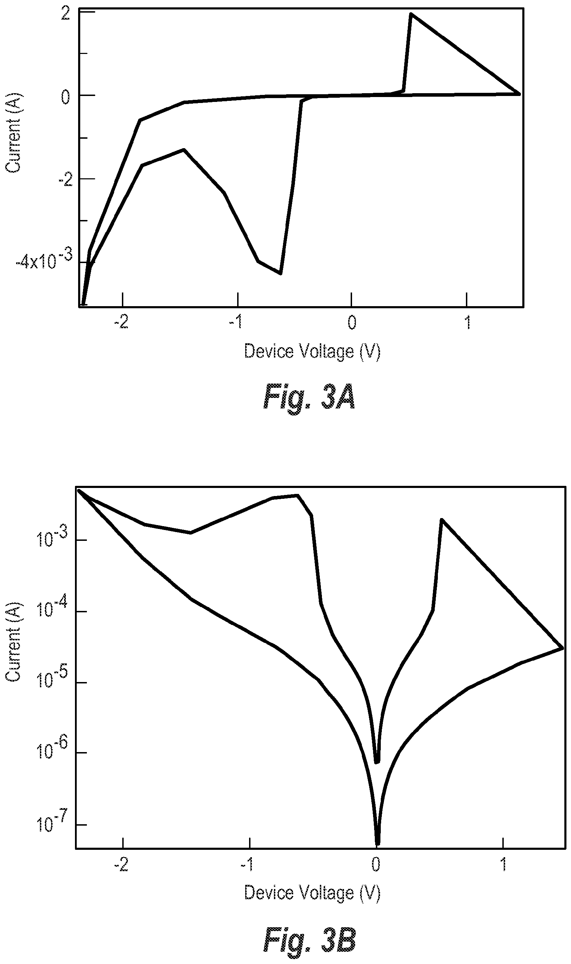

FIG. 2A, on coordinates of current (in A) and device voltage (in V), is a plot of switching current/voltage loops for the system Pt/TaOₓ/nanocap VO₂/V, in accordance with principles disclosed herein

### DETAILED DESCRIPTION

Reference is now made in detail to specific examples of the disclosed nonlinear memristor and specific examples of ways for creating the disclosed nonlinear memristor. When applicable, alternative examples are also briefly described.

Nonlinear electrical devices do not exhibit a linear current/voltage (I/V) relationship. Examples of nonlinear electrical devices include diodes, transistors, some semiconductor structures, and other devices, such as memristors. Nonlinear electrical devices can be used in a wide variety of applications, including amplifiers, oscillators, signal/power conditioning, computing, memory, and other applications.

However, while memristors may typically exhibit nonlinearity in the high resistance state, their linear I/V characteristic in the low resistance state may limit their application, such as in large passive crossbar arrays.

As used in the specification and claims herein, the singular forms "a," "an," and "the" include plural referents unless the context clearly dictates otherwise.

As used in this specification and the appended claims, "approximately" and "about" mean a ±10% variance caused by, for example, variations in manufacturing processes.

In the following detailed description, reference is made to the drawings accompanying this disclosure, which illustrate specific examples in which this disclosure may be practiced. The components of the examples can be positioned in a number of different orientations and any directional terminology used in relation to the orientation of the components is used for purposes of illustration and is in no way limiting. Directional terminology includes words such as "top," "bottom," "front," "back," "leading," "trailing," etc.

It is to be understood that other examples in which this disclosure may be practiced exist, and structural or logical changes may be made without departing from the scope of the present disclosure. Therefore, the following detailed description is not to be taken in a limiting sense. Instead, the scope of the present disclosure is defined by the appended claims.

Memristors are nano-scale devices that may be used as a component in a wide range of electronic circuits, such as memories, switches, and logic circuits and systems. In a memory structure, a crossbar of memristors may be used. When used as a basis for memories, the memristor may be used to store a bit of information, 1 or 0. When used as a logic circuit, the memristor may be employed as configuration bits and switches in a logic circuit that resembles a Field Programmable Gate Array (FPGA), or may be the basis for a wired-logic Programmable Logic Array (PLA).

When used as a switch, the memristor may either be a closed or open switch in a cross-point memory. During the last few years, researchers have made great progress in finding ways to make the switching function of these memristors behave efficiently. For example, tantalum oxide (TaOₓ)-based memristors have been demonstrated to have superior endurance over other nano-scale devices capable of electronic switching. In lab settings, tantalum oxide-based memristors are capable of over 10 billion switching cycles whereas other memristors, such as tungsten oxide (WOₓ)- or titanium oxide (TiOₓ)-based memristors, may require a sophisticated feedback mechanism for avoiding overdriving the devices or an additional step of refreshing the devices with stronger voltage pulses in order to obtain an endurance in the range of 10 million switching cycles.

Memristor devices typically may comprise two electrodes sandwiching an insulating layer. One or more conducting channels in the insulating layer between the two electrodes may be formed that are capable of being switched between two states, one in which the conducting channel forms a conductive path between the two electrodes ("ON") and one in which the conducting channel does not form a conductive path between the two electrodes ("OFF").

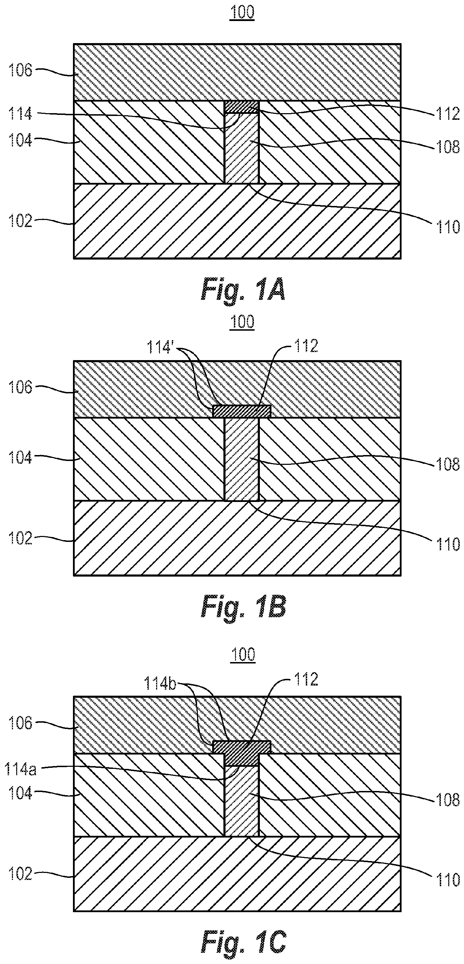

In accordance with the teachings herein, a nonlinear memristor is provided. Examples of the device are depicted in FIGS. 1A-1C. As shown in each of the three figures, the device 100 comprises a bottom, or first, electrode 102, an insulator layer 104, and a top, or second, electrode 106.

The device further includes a switching channel 108 within the insulator layer 104 and extending from the bottom electrode 102 toward the top electrode 106. The switching channel 108 forms a switching interface 110 with the bottom electrode 102. Although one switching channel 108 is shown, there may be more than one switching channel present, although even at a point of time, typically one channel dominates the switching.

The switching channel 108 does not contact the top electrode 106, and instead stops short, leaving a region. As shown in FIG. 1A, the region between the top of the switching channel 108 and the top electrode 106 is occupied by a nano-cap layer 112 of a metal-insulator-transition material. The top electrode 106 is seen to contact both the nano-cap layer 112 and the insulator layer 104 that surrounds the nano-cap layer and the conducting channel 108.

In the formation of the nano-cap layer 112, growth advances along a growth front, denoted 114, from the top electrode 106 into the conducting channel 108. Growth of the nano-cap layer 112 may be limited by diffusion of metal (cation) from the top electrode 106 through the nano-cap layer.

FIG. 1B depicts another example for the formation of the nano-cap layer 112. In this example, the conducting channel 108 extends from the bottom electrode 102 to the top electrode 106, and the nano-cap layer 112 is formed by diffusion of oxygen from the conducting channel into the top electrode, along a growth front 114'. In this example, growth of the nano-cap layer 112 may be limited by diffusion of oxygen (anion) through the nano-cap layer.

FIG. 1C depicts yet another example for the formation of the nano-cap layer 112. In this example, the conducting channel 112 is essentially a combination of the growth mechanisms depicted in FIGS. 1A and 1B, with metal (cation) diffusing from the top electrode 106 into the conducting channel 108 and oxygen diffusing from the conducting channel into the top electrode, along growth fronts 114a and 114b, respectively. Both the metal and the oxygen diffuse under their own chemical potential gradients. A "mushroom-shaped" structure may be formed.

Examples of electrode materials for the bottom electrode may include, but are not limited to, platinum (Pt), aluminum (Al), copper (Cu), gold (Au), molybdenum (Mo), niobium (Nb), palladium (Pd), ruthenium (Ru), ruthenium oxide (RuO₂), silver (Ag), tantalum (Ta), tantalum nitride (TaN), titanium nitride (TiN), tungsten (W), and tungsten nitride (WN).

Any of the metal oxides commonly employed for memristor devices may be used as the insulator layer 104. In some examples, the insulator layer 104 may include a transition metal oxide, such as tantalum oxide, titanium oxide, yttrium oxide, hafnium oxide, zirconium oxide, or other like oxides, or may include a metal oxide, such as aluminum oxide, calcium oxide, or magnesium oxide, or other like oxides. In other examples, the material of the insulating layer 104 may be ternary oxides, quaternary oxides, or other complex oxides, such as strontium titanate oxide (STO) or praseodymium calcium manganese oxide (PCMO).

In some examples, the insulator layer 104 may be TaOₓ, where x ranges from about 2 to 2.5. In other examples, the insulator layer may be HfOₓ, where y ranges from about 1.5 to 2. Both of these oxides (TaOₓ and HfOₓ) have exhibited excellent electrical performance.

The switching channel 108 may be a phase supersaturated with oxygen. However, it is a phase with less oxygen than the insulating oxide layer.

For example, if the insulator layer 104 is TaOₓ, then the switching channel 108 may include a metal phase (tantalum) with supersaturated oxygen, represented as Ta(O). In terms of the formula TaO_{y}, y is less than 2. Likewise, if the insulator layer 104 is HfOₓ, then the switching channel 108 may include a metal phase (hafnium) with supersaturated oxygen, represented as Hf(O). In terms of the formula HfO_{y}, y is less than 1.5.

The supersaturated oxygen phase may be formed by an electrical approach, for example. In the case of the TaOₓ insulating phase, when a voltage is applied, phase separation takes place, forming a phase containing a insulating metal oxide, (close to TaO_{2.5}) and a phase containing metal (here, tantalum) supersaturated with oxygen. Essentially, phase decomposition from the insulating TaOₓ (2< x <2.5) a tantalum oxygen solid solution with supersaturated oxygen in the solution takes place. The same considerations obtain for the HfO₂ phase.

The MIT material of the nano-cap layer 112 may be a high order oxide of a metal that is also as conductive as possible at the switching moment; that is, the metal oxide is electrically conductive at high temperature (T); in other words, the temperature is used to control the switching current such that at high temperature, the oxide becomes conductive. Suitable examples of oxides that evidence these two criteria include Ti₃O₅, Ti₂O₃, VO₂ and NbO₂. By a high order oxide is meant that the phase contains as much oxygen as possible. There are two competing aspects: a desire to have as much oxygen as possible, but also to be as conductive as possible at high temperature (the temperature to which the conduction channel is heated up by Joule heating), yet lower oxygen results in higher conductivity. Thus, VO₂, which has less oxygen than V₂O₅, and NbO₂, which has less oxygen than Nb₂O₅, meet both conditions.

The nonlinear current/voltage relation for passive crossbar applications is improved by incorporating the nano-cap structure, which employs a metal/insulator/transition material (MIT). Specifically, the nano-cap layer 112 may have a composition of either VO₂ or NbO₂. Examples of other suitable oxides include, but are not limited to, Ti₂O₃ and Ti₃O₅. The thickness of the nano-cap layer 112 may be less than 1 nm. In other examples, the thickness of the nano-cap layer 112 may be about one-half the thickness of the insulating layer 104, or about 2 to 50 nm.

The top electrode may be the same metal as the metal oxide comprising the nano-cap layer. So, for example, for a nano-cap layer of VO₂, the top electrode may be V, and for a nano-cap layer of NbO₂, the top electrode may be Nb. For other oxides, such as Ti₂O₃, the top electrode would be the metal of that oxide, in this case Ti or Ti suboxide, such as TiO, etc.

Metal-insulator transitions are transitions from a metal (material with good electrical conductivity of electric charges) to an insulator (material where conductivity of charges is quickly suppressed). These transitions can be achieved by tuning various ambient parameters such as temperature or pressure. In the case of VO₂ or NbO₂, for example, the lower temperature state is insulating and the higher temperature state is conducting. For examples of the nonlinear behavior of MIT materials, see, e.g., Alexander Pergament et al, "Switching Effects in Oxides of Vanadium, Nickel, and Zinc", Journal of International Research Publications: Materials Methods & Technologies, Vol. 2, pp. 17-28 (2007).

Without subscribing to any particular theory, it appears that the nonlinearity of the MIT material of the nano-cap layer 112 contributes to the asymmetrical (nonlinear) I/V behavior of the memristors 100 in the low resistance state via current-controlled negative differential resistance. The small switching channel 108, with a width less than 100 nm or less than 60 nm or less than 20 nm or less than 10 nm or less than 5 nm, along with the very insulative material surrounding the channel, contributes to a low switching current, which results in a low switching energy (typically a picojoule or less).

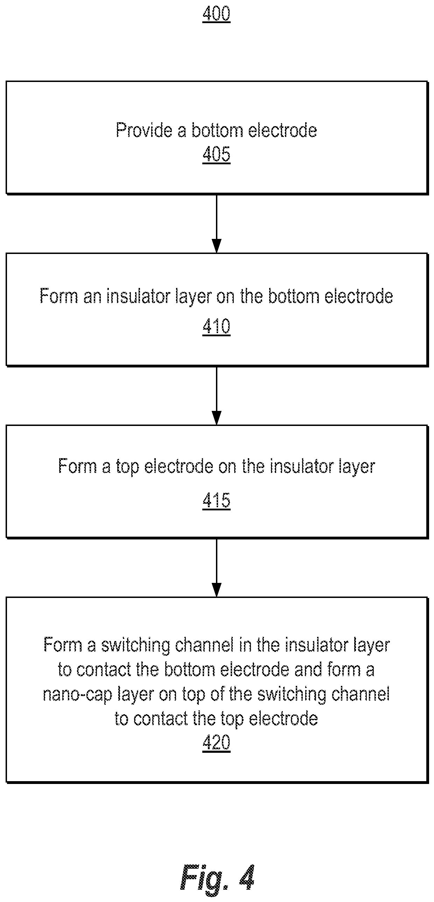

A method 400 of preparing the nonlinear memristor described herein is depicted in FIG. 4. A bottom electrode 102 is provided 405. An insulating layer 104 is formed 410 on the bottom electrode 102. A top electrode 106 is formed 415 on the insulating layer 104. A switching channel 108 is formed 420 in the insulator layer 104 to contact the bottom electrode 102 and essentially simultaneously, a nano-cap layer 112 is formed on top of the switching channel to contact the top electrode 106.

The bottom electrode 102 is provided 405 by any of the common procedures for forming metal electrodes. Examples include, but are not limited to, sputtering, evaporation, ALD (atomic layer deposition), co-deposition, chemical vapor deposition, IBAD (ion beam assisted deposition), or any other film deposition technology. The thickness of the first electrode 102 may be in the range of about 10 nm to a few micrometers.

The insulating layer 104 is formed 410 by any of the common procedures for forming insulating metal oxide layers. Examples include, but are not limited to, deposition by sputtering, atomic layer deposition, chemical vapor deposition, evaporation, co-sputtering (using two metal oxide targets, for example), or other such process. The thickness of the insulating layer 104 may be about 3 to 100 nm.

The top electrode 106 is formed 415 by any of the common procedures for forming metal electrodes, including any of those described above for forming the bottom electrode 102. The thickness of the top electrode 106 may be in the range of about 10 nm to a few micrometers.

The formation 420 of the switching channel 108 and the nano-cap layer 112 may be done in a number of ways. An example of one suitable method includes the electroforming process often used to form switching channels in memristors, namely, the application of a quasi-DC voltage sweep /pulse with limited current. Sweep means a voltage that increases from 0 V to a certain level slowly in a quasi-DC mode; pulse is a very fast voltage pulse, such as 2 V for 100 ns. it can be a current compliance (largest current limit) exerted by the circuit. In some examples, the voltage may sweep from about +2V to -2V and back.

Essentially simultaneously, because the top electrode 106 comprises the metal desired for the metal oxide of the nano-cap layer 112, the voltage sweep causes the formation of the metal oxide to create the nano-cap layer. The switching channel 108 may be the main oxygen source, since it is oxygen oversaturated.

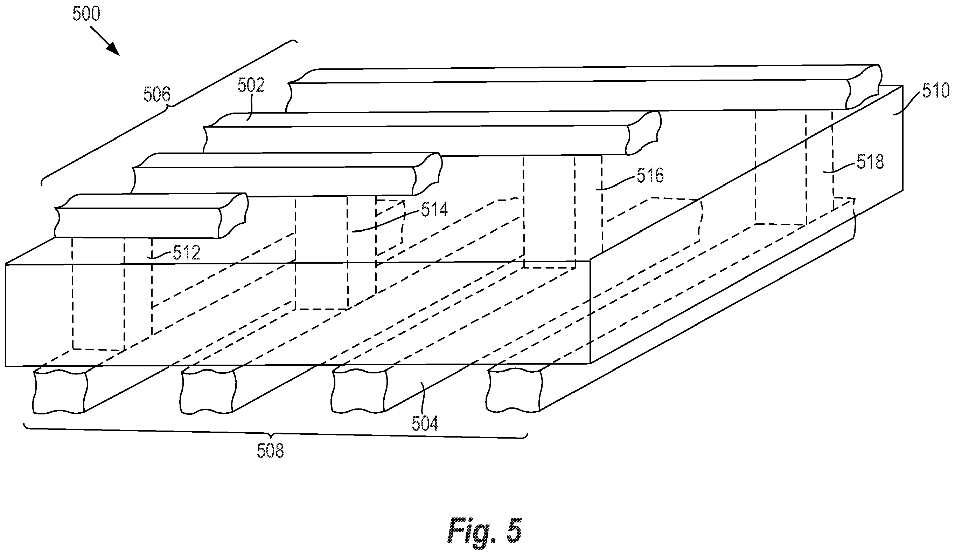

The nonlinear device may be used in a memory array. FIG. 5 shows a perspective view of a nanowire memory array, or crossbar, 500, revealing an intermediate layer 510 disposed between a first layer of approximately parallel nanowires 508 and a second layer of approximately parallel nanowires 506. The first layer of nanowires may be at a non-zero angle relative to the second layer of nanowires.

According to one illustrative example, the intermediate layer 510 may be a dielectric layer. A number of the nonlinear devices 512-518 may be formed in the intermediate layer 510 at the intersections, or junctions, between nanowires 502 in the top layer 506 and nanowires 504 in the bottom layer 508. The nanowires may serve as the upper and lower conductive layers 106, 102, respectively, in the nonlinear device 100. For example, when forming a nonlinear device similar to the example shown in FIGS. 1A-1C, the wires in the top layer 506 could be formed from vanadium or niobium, depending on the metal used to form the nano-cap layer 112, and the nanowires in the bottom layer 508 could be formed from platinum. The upper nanowires would then serve as the top electrode 106 and the lower nanowires would serve as the bottom electrode 102. Alternatively, other conductive materials may be used as the upper and lower nanowires 502 and 504.

For purposes of illustration, only a few of the nonlinear devices 512-518 are shown in FIG. 5. Each of the combined devices 512-518 may be used to represent one or more bits of data. For example, in the simplest case, a nonlinear device may have two states: a conductive state and a nonconductive state. The conductive state may represent a binary "1" and the nonconductive state may represent a binary "0", or visa versa. Binary data can be written into the nanowire memory array 500 by changing the conductive state of the memristive matrix within the nonlinear devices. The binary data can then be retrieved by sensing the conductive state of the nonlinear devices 512-518.

The example above is only one illustrative example of the nanowire memory array 500. A variety of other configurations could be used. For example, the memory array 500 can incorporate nonlinear elements that have different structures. The different structures could include more or less layers, layers that have different compositions than described above, and layers that are ordered in different ways than shown in the example given above. For example, the memory array could include memristors, memcapacitors, meminductors, or other memory elements. Further, the memory array could use a wide range of conductors to form the crossbars.

It should be understood that the memristors described herein, such as the example memristor depicted in FIG. 1, may include additional components and that some of the components described herein may be removed and/or modified without departing from the scope of the memristor disclosed herein. It should also be understood that the components depicted in the Figures are not drawn to scale and thus, the components may have different relative sizes with respect to each other than as shown therein. For example, the upper, or second, electrode 106 may be arranged substantially perpendicularly to the lower, or first, electrode 102 or may be arranged at some other non-zero angle with respect to each other. As another example, the insulating layer 104 may be relatively smaller or relatively larger than either or both electrode 102 and 106.

Advantageously, excellent electrical performance is obtained, as seen from the experimental results. The process is relatively easy to implement, and at relatively low cost.

## Claims

1. A nonlinear memristor (100) including:
a bottom electrode (102);
a top electrode (106);
an insulator layer (104) between the bottom electrode (102) and the top electrode (106), the insulator layer (104) comprising a metal oxide;
a switching channel (108) within the insulator layer (104), extending from the bottom electrode (102) toward the top electrode (106); and
a nano-cap layer (112) of a metal-insulator-transition material between the switching channel (108) and the top electrode (106),
wherein the switching channel (108) has a width of less than 110 nm and the nano-cap layer (112) has a thickness less than 55 nm;
the top electrode (106) contacts both the nano-cap layer (112) and the insulator layer (104);
the insulator layer (104) surrounds and contacts the switching channel (108); and, **characterized in that** the switching channel (108) includes a phase having less oxygen than the metal oxide of the insulator layer (104).

2. The nonlinear memristor of claim 1, wherein the insulator layer (104) comprises a metal oxide selected from the group consisting of TaOₓ, where x is within a range of 1.8 to 2.75, and HfO_{y}, where y is within a range of 1.35 to 2.2.

3. The nonlinear memristor of claim 1 wherein the insulator layer (104) is TaOₓ, where x is within a range of 2 to 2.5, and wherein the switching channel (108) is Ta-oxygen solid solution with supersaturated oxygen.

4. The nonlinear memristor of claim 1 wherein the insulator layer is HfOₓ, where x is within a range of 1.5 to 2, and wherein the switching channel (108) is Hf-oxygen solid solution with supersaturated oxygen.

5. The nonlinear memristor of claim 1, wherein the metal-insulator-transition material of the nano-cap layer (112) is a high order oxide of a metal that is also as conductive as possible at the switching moment.

6. The nonlinear memristor of claim 5, wherein the metal-insulator-transition material of the nano-cap layer (112) is VO₂ and the top electrode (106) is either V or VOₓ, where 0 < x < 2.

7. The nonlinear memristor of claim 5, wherein the metal-insulator-transition material of the nano-cap layer (112) is NbO₂ and the top electrode (106) is either Nb or NbOₓ, where 0 < x < 2.

8. The nonlinear memristor of claim 5, wherein the metal-insulator-transition material of the nano-cap layer (112) is either Ti₃O₅ or Ti₂O₃ and the top electrode (106) is either Ti or TiOₓ, where 0 < x < 1.5.

9. The nonlinear memristor of claim 1 wherein the top electrode (106) comprises the same metal as the metal in the metal-insulator-transition material.

10. The nonlinear memristor of claim 1, wherein the bottom electrode (102) is selected from the group consisting of platinum, aluminum, copper, gold, molybdenum, niobium, palladium, ruthenium, ruthenium oxide, silver, tantalum, tantalum nitride, titanium nitride, tungsten, and tungsten nitride.

11. A method (400) of forming the nonlinear memristor of claim 1, including:
providing (405) the bottom electrode (102);
forming (410) the insulator layer (104) on the bottom electrode (102);
forming (415) the top electrode (106) on the insulator layer (104); and
forming (420) the switching channel (108) in the insulator layer (104) and the nano-cap layer (112) on top of the switching channel (108), the insulator layer (104) surrounding and contacting the switching channel (108) and the switching channel (108) including a phase having less oxygen than the metal oxide comprising the insulator layer (104).

12. The method of claim 11 wherein the switching channel (108) and the nano-cap layer (112) are formed by an electrical operation process comprising the application of a voltage sweep/pulse with limited current.

13. The method of claim 12 wherein the switching channel (108) and the nano-cap layer (112) are formed by an electroforming process.

14. A crossbar (500) comprising an array of approximately first nanowires (508) and an array of approximately second nanowires (506), the array of first nanowires crossing the array of second nanowires at a non-zero angle, each intersection of a first nanowire with a second nanowire forming a junction, with the nonlinear memristor of claim 1 at each junction, sandwiched between a first nanowire (504) and a second nanowire (502).

## Patentansprüche

1. Nichtlinearer Memristor (100), der Folgendes aufweist:
eine untere Elektrode (102);
eine obere Elektrode (106);
eine Isolierschicht (104) zwischen der unteren Elektrode (102) und der oberen Elektrode (106), wobei die Isolierschicht (104) ein Metalloxid umfasst;
einen Schaltkanal (108) in der Isolierschicht (104), der sich von der unteren Elektrode (102) in Richtung der oberen Elektrode (106) erstreckt; und
eine Nano-Kappenschicht (112) aus einem Metall-Isolator-Übergangsmaterial zwischen dem Schaltkanal (108) und der oberen Elektrode (106),
wobei der Schaltkanal (108) eine Breite von weniger als 110 nm aufweist und die Nano-Kappenschicht (112) eine Dicke von weniger als 55 nm aufweist;
die obere Elektrode (106) sich sowohl mit der Nano-Kappenschicht (112) als auch der Isolierschicht (104) in Kontakt befindet;
die Isolierschicht (104) den Schaltkanal (108) umgibt und sich in Kontakt mit ihm befindet; und
**dadurch gekennzeichnet, dass** der Schaltkanal (108) eine Phase einschließt, die weniger Sauerstoff aufweist als das Metalloxid der Isolierschicht (104).

2. Nichtlinearer Memristor nach Anspruch 1, wobei die Isolierschicht (104) ein Metalloxid umfasst, dass aus der Gruppe bestehend aus TaOₓ, wobei x im Bereich von 1,8 bis 2,75 liegt, und HfO_{y}, wobei y im Bereich von 1,35 bis 2,2 liegt, ausgewählt wurde.

3. Nichtlinearer Memristor nach Anspruch 1, wobei die Isolierschicht (104) aus TaOₓ besteht, wobei x im Bereich von 2 bis 2,5 liegt, und wobei der Schaltkanal (108) aus Ta-Sauerstoff-Mischkristall mit übersättigtem Sauerstoff besteht.

4. Nichtlinearer Memristor nach Anspruch 1, wobei die Isolierschicht aus HfOₓ besteht, wobei x im Bereich von 1,5 bis 2 liegt, und wobei der Schaltkanal (108) aus Hf-Sauerstoff-Mischkristall mit übersättigtem Sauerstoff besteht.

5. Nichtlinearer Memristor nach Anspruch 1, wobei das Metall-Isolator-Übergangsmaterial der Nano-Kappenschicht (112) aus einem hochwertigen Oxid eines Metalls besteht, das im Schaltmoment auch so leitfähig wie möglich ist.

6. Nichtlinearer Memristor nach Anspruch 5, wobei das Metall-Isolator-Übergangsmaterial der Nano-Kappenschicht (112) aus VO₂ und die obere Elektrode (106) entweder aus V oder VOₓ besteht, wobei 0 < x < 2.

7. Nichtlinearer Memristor nach Anspruch 5, wobei das Metall-Isolator-Übergangsmaterial der Nano-Kappenschicht (112) aus NbO₂ und die obere Elektrode (106) entweder aus Nb oder NbOₓ besteht, wobei 0 < x < 2.

8. Nichtlinearer Memristor nach Anspruch 5, wobei das Metall-Isolator-Übergangsmaterial der Nano-Kappenschicht (112) entweder aus Ti₃0₅ oder Ti₂0₃ und die obere Elektrode (106) entweder aus Ti oder TiOₓ besteht, wobei 0 < x < 1,5.

9. Nichtlinearer Memristor nach Anspruch 1, wobei die obere Elektrode (106) dasselbe Metall wie das Metall im Metall-Isolator-Übergangsmaterial umfasst.

10. Nichtlinearer Memristor nach Anspruch 1, wobei die untere Elektrode (102) aus der Gruppe bestehend aus Platin, Aluminium, Kupfer, Gold, Molybdän, Niob, Palladium, Ruthenium, Rutheniumoxid, Silber, Tantal, Tantalnitrid, Titannitrid, Wolfram und Wolframnitrid ausgewählt wurde.

11. Verfahren (400) zum Ausbilden des nichtlineareren Memristors nach Anspruch 1, das Folgendes beinhaltet:
Bereitstellen (405) der unteren Elektrode (102);
Ausbilden (410) der Isolierschicht (104) an der unteren Elektrode (102);
Ausbilden (415) der oberen Elektrode (106) an der Isolierschicht (104); und
Ausbilden (420) des Schaltkanals (108) in der Isolierschicht (104) und der Nano-Kappenschicht (112) über dem Schaltkanal (108), wobei die Isolierschicht (104) den Schaltkanal (108) umgibt und in Kontakt mit ihm ist und der Schaltkanal (108) eine Phase einschließt, die weniger Sauerstoff als das die Isolierschicht (104) umfassende Metalloxid aufweist.

12. Verfahren nach Anspruch 11, wobei der Schaltkanal (108) und die Nano-Kappenschicht (112) durch einen elektrischen Wirkprozess ausgebildet werden, der die Anwendung eines Spannungs-Sweeps/Impulses mit begrenzter Stromstärke umfasst.

13. Verfahren nach Anspruch 12, wobei der Schaltkanal (108) und die Nano-Kappenschicht (112) durch ein Elektroformungsverfahren ausgebildet werden.

14. Kreuzschiene (500) ein Array aus annähernd ersten Nanodrähten (508) und ein Array aus annähernd zweiten Nanodrähten (506) umfassend, wobei das Array aus ersten Nanodrähten das Array aus zweiten Nanodrähten in einem Winkel ungleich Null kreuzt, wobei jeder Kreuzungspunkt eines ersten Nanodrahts mit einem zweiten Nanodraht eine Verbindung bildet und an jeder Verbindung der nichtlinearere Memristor nach Anspruch 1 zwischen einem ersten Nanodraht (504) und einem zweiten Nanodraht (502) angeordnet ist.

## Revendications

1. Memristor non-linéaire (100) comportant :
une électrode inférieure (102) ;
une électrode supérieure (106) ;
une couche isolante (104) entre l'électrode inférieure (102) et l'électrode supérieure (106), la couche isolante (104) comprenant un oxyde métallique ;
un canal de commutation (108) à l'intérieur de la couche isolante (104), s'étendant de l'électrode inférieure (102) vers l'électrode supérieure (106) ; et
une nano-couche couvercle (112) constituée d'un matériau de transition entre métal/isolant entre le canal de commutation (108) et l'électrode supérieure (106),
dans lequel le canal de commutation (108) possède une largeur inférieure à 110 nm et la nano-couche couvercle (112) possède une épaisseur inférieure à 55 nm ;
l'électrode supérieure (106) entre en contact à la fois avec la nano-couche couvercle (112) et la couche isolante (104) ;
la couche isolante (104) entoure et entre en contact avec le canal de commutation (108); et,
**caractérisé en ce que** le canal de commutation (108) comporte une phase ayant moins d'oxygène que l'oxyde métallique de la couche isolante (104).

2. Memristor non-linéaire selon la revendication 1, dans lequel la couche isolante (104) comprend un oxyde métallique choisi dans le groupe constitué de TaOₓ, où x se situe dans une plage allant de 1,8 à 2,75, et HfO_{y}, où y se situe dans une plage allant de 1,35 à 2,2.

3. Memristor non-linéaire selon la revendication 1, dans lequel la couche isolante (104) est du TaOₓ, où x se situe dans une plage allant de 2 à 2,5, et dans lequel le canal de commutation (108) est une solution solide de Ta-oxygène avec de l'oxygène sursaturé.

4. Memristor non-linéaire selon la revendication 1, dans lequel la couche isolante est HfOₓ, où x se situe dans une plage allant de 1,5 à 2, et dans lequel le canal de commutation (108) est une solution solide de Hf-oxygène avec de l'oxygène sursaturé.

5. Memristor non-linéaire selon la revendication 1, dans lequel le matériau de transition entre le métal/isolant de la nano-couche couvercle (112) est un oxyde d'ordre supérieur d'un métal qui est également aussi conducteur que possible au moment de la commutation.

6. Memristor non-linéaire selon la revendication 5, dans lequel le matériau de transition entre le métal/isolant de la nano-couche couvercle (112) est VO₂ et l'électrode supérieure (106) est soit V soit VOₓ, où 0 < x < 2.

7. Memristor non-linéaire selon la revendication 5, dans lequel le matériau de transition entre le métal/isolant de la nano-couche couvercle (112) est NbO₂ et l'électrode supérieure (106) est soit Nb soit NbOₓ, où 0 < x < 2.

8. Memristor non-linéaire selon la revendication 5, dans lequel le matériau de transition entre le métal/isolant de la nano-couche couvercle (112) est soit Ti₃O₅ soit Ti₂O₃ et l'électrode supérieure (106) est soit Ti soit TiOₓ, où 0 < x < 1,5.

9. Memristor non-linéaire selon la revendication 1, dans lequel l'électrode supérieure (106) comprend le même métal que le métal dans le matériau de transition entre le métal/isolant.

10. Memristor non-linéaire selon la revendication 1, dans lequel l'électrode inférieure (102) est choisie dans le groupe constitué du platine, de l'aluminium, du cuivre, de l'or, du molybdène, du niobium, du palladium, du ruthénium, de l'oxyde de ruthénium, de l'argent, du tantale, du nitrure de tantale, du nitrure de titane, du tungstène et du nitrure de tungstène.

11. Procédé (400) consistant à former le memristor non-linéaire selon la revendication 1, comportant les étapes suivantes :
fournir (405) l'électrode inférieure (102) ;
former (410) la couche isolante (104) sur l'électrode inférieure (102) ;
former (415) l'électrode supérieure (106) sur la couche isolante (104) ; et
former (420) le canal de commutation (108) dans la couche isolante (104) et la nano-couche couvercle (112) au sommet du canal de commutation (108), la couche isolante (104) entourant et mettant en contact le canal de commutation (108) et le canal de commutation (108) comportant une phase ayant moins d'oxygène que l'oxyde métallique comprenant la couche isolante (104).

12. Procédé selon la revendication 11, dans lequel le canal de commutation (108) et la nano-couche couvercle (112) sont formés par un processus d'opération électrique comprenant l'application d'un balayage de tension/d'une impulsion de tension avec un courant limité.

13. Procédé selon la revendication 12, dans lequel le canal de commutation (108) et la nano-couche couvercle (112) sont formés par un processus d'électroformage.

14. Barre transversale (500) comprenant un réseau d'approximativement des premiers nanofils (508) et un réseau d'approximativement des seconds nanofils (506), le réseau de premiers nanofils traversant le réseau de seconds nanofils selon un angle non-nul, chaque intersection d'un premier nanofil avec un second nanofil formant une jonction, avec le memristor non-linéaire selon la revendication 1 à chaque jonction, pris en sandwich entre un premier nanofil (504) et un second nanofil (502).
